# EUROPEAN PATENT SPECIFICATION

(11) **EP 0 348 345 B1**
(45) Date of publication and mention of the grant of the patent: **14.02.1996**
(21) Application number: 89810444.3
(22) Date of filing: 13.06.1989
(51) Int. Cl.: C08F 222/40, C08G 73/12, C08J 5/24

(54) **Solution stable polyimide resin systems**
Lösungsmittelstabile Polyimidharzsysteme
Systèmes du résine polyimide résistant au solvant

(30) Priority: 20.06.1988 US 209381
(43) Date of publication of application: 27.12.1989
(73) Proprietor: CIBA-GEIGY AG, CH-4002 Basel (CH)
(72) Inventor: Maw, Taishih, Yorktown Heights New York 10598 (US); Kritchevsky, Gina, Danbury Connecticut 06811 (US); Cheng, Chi-Wen Frank, Spring Valley New York 10977 (US)

(56) References cited:
- EP-A- 0 014 816
- EP-A- 0 175 648
- EP-A- 0 296 112
- EP-A- 0 302 832
- DE-A- 2 627 045
- GB-A- 2 126 240
- US-A- 4 038 251
- US-A- 4 752 641

## Description

### Solution Stable Polyimide Resin Systems

The invention relates to specific advanced polyimide reaction products and solutions thereof, the desired degree of resin advancement being reflected in melt viscosity values, as well as to a process for the preparation of said advanced products.

It is known that polymaleimides can be utilized for the preparation of various polyaddition and polymerization products. Particular emphasis has been placed on bis-maleimide materials which exhibit thermal stability and good mechanical properties and thus are being more frequently utilized in high performance composite applications.

The currently utilized bis-maleimide systems include aromatic amines or alkenyl phenols as coreactants. U.S. 3,658,764 and Re. 29,316 are examples of patents that disclose reaction products of unsaturated bis-imides and amines. U.S. 4,100,140, U.S. 4,127,615, U.S. 4,130,600 and U.S. 4,131,632 are examples of patents that disclose crosslinked polymers resulting from the reaction of polymaleimides with alkenyl phenols or alkenyl phenol ethers optionally in the presence of epoxy resins. U.S. 4,038,251 discloses polyimide/polyhydric phenol reaction products prepared in the presence of amines.

A standard polymide product conventionally used for various prepreg applications comprises the reaction product of bismaleimidodiphenyl methane with methylene dianiline. The product is supplied as a solid powder to be dissolved in N-methylpyrrolidone for prepreg use. It has been noted, however, that the product is soluble only in the above noted solvent or similar high boiling, difficult to process solvents. Correspondingly, solution stability of these systems is limited as evidenced by rapidly occurring precipitation and viscosity increases. These factors necessitate that the prepolymer be formulated immediately prior to use.

Improvements in such systems are noted in the products disclosed in U.S. 4,100,140 (see above). Such products, based primarily on the reaction of bismaleimidodiphenyl methane and diallyl bisphenol A prepared in the optional presence of amine polymerization catalysts, exhibit improved thermal, chemical and mechanical properties. However, these systems still have certain disadvantages in terms of storage stability and limited solubility. For example, the system is insoluble in conventional ketonic solvents and, when stored in higher boiling solvent solution, precipitates out of solution after short periods of time. Accordingly, its applicability for use in making solvent impregnated laminates is limited.

It is the primary object of this invention to provide polymaleimide - based reaction products which substantially eliminate the disadvantages encountered with prior art materials.

It is a further object to provide such improved reaction products without any substantial adverse impact on the thermal and mechanical properties thereof.

It is another object to provide a process with defined reaction parameters for preparing such materials.

Various other objects and advantages of this invention will become apparent from the following descriptive material.

It has now been surprisingly discovered that by reacting the polymaleimide with an alkenylphenol or alkenyl phenol ether in the presence of specified molar amounts of a basic catalyst at elevated temperatures in order to obtain a predetermined amount of resin advancement, polymaleimide prepolymers are obtained with significantly improved characteristics. Thus, by defining the process parameters in terms of catalyst composition, catalyst concentration, reaction time and reaction temperature, appropriately advanced prepolymers based on exhibited melt viscosity and resin solution stability are obtained which exhibit a broad range of improved and desired performance features. In particular, the reaction products are soluble in relatively low boiling solvents such as methyl ethyl ketone and propylene glycol methyl ether which facilitates subsequent processing thereof as evidenced by increased treating speeds (greater ease of solvent removal), decreased toxicity and reduced residual volatiles in the resulting prepregs. They are stable in solution for prolonged periods of time at varied storage temperatures as evidenced by the substantial absence of precipitation as well as in neat resin form. They exhibit greater flexibility of use by eliminating the need for mixing of powders and for two-component systems and by being available instead as preformulated, ready-to-use materials. The prepregs and laminates prepared with these systems exhibit substantially the same excellent thermal, chemical and mechanical properties as laminates and prepregs prepared with the prior art materials.

Subject of the invention is a heat curable composition comprising the product resulting from the reaction of (a) a polyimide containing at least two radicals of the formula 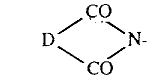 wherein D is a divalent radical containing a C=C bond, and (b) from 0.05 to 2.0 moles per mole of component (a) of an alkenyl phenol, an alkenyl phenol ether or mixtures thereof, in the presence of from 0.01 to 0.11 moles per one mole for each two imide moieties in component (a) of a primary, secondary or tertiary amine, mixed secondary/tertiary amine, heterocyclic base or quaternary ammonium compound as a basic catalyst, said reaction product having a resin melt viscosity of from 21 to 75 poise as measured on an ICI Cone & Plate Viscometer at 125°C.

Applicable polyimides contain at least two radicals of the formula 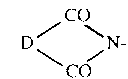 wherein D is a divalent radical containing a C=C bond. These polyimides are known compounds and are described, for example, in U.S. 4,100,140. They are preferably bismaleimides of the formula 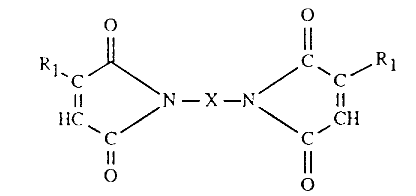 wherein R₁ is hydrogen or methyl and X is a divalent organic radical with 2-30 carbon atoms and, more particularly, wherein X is -CₓH₂ₓ- with x = 2-20, -CH₂CH₂SCH₂CH₂-, phenylene, naphthylene, xylylene, cyclopentylene, 1,5,5-trimethy1-1,3-cyclohexylene, 1,4-cyclohexylene, 1,4bis(methylene)cyclohexylene, and groups of the formula 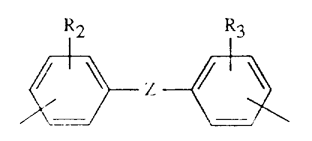 wherein R₂ and R₃ independently are chlorine, bromine, methyl, ethyl or hydrogen, and Z is a direct bond or methylene, 2,2-propylidene, -CO-, -O-, -S-, -SO- or -SO₂-. Bis-maleimides which are particularly preferred are those in which R₁ is hydrogen, X is hexamethylene, trimethylhexamethylene, 1,5,5-trimethyl-1,3-cyclohexylene, or a group of the indicated formula in which Z is methylene, 2,2-propylidene or -O-.

The substances which follow may be mentioned as specific examples of known polyimides which are suitable for use in this invention: N,N'ethylene-bis-maleimide, N,N'-hexamethylene-bis-maleimide, N,N'-m-phenylene-bis-maleimide, N,N'-p-phenylene-bis-maleimide, N,N'-4,4'-diphenylmethane-bis-maleimide (this is preferably employed), N,N'-4,4'-3,3'-dichloro-diphenylmethane, N,N'-4,4'-(diphenyl ether)-bis-maleimide, N,N'-4,4'-diphenyl-sulphone-bis-maleimide, N,N'-4,4'-dicyclohexylmethane-bis-maleimide, N,N'-alpha,alpha'-4,4'-dimethylenecydohexane-bismaleimide, N,N'-m-xylylene-bis-maleimide, N,N'-p-xylylene-bis-maleimide, N,N'-4,4'-diphenylcyclohexane-bis-maleimide, N,N'-m-phenylene-bis-citraconimide, N,N'-4,4'-diphenylmethane-bis-citraconimide, N,N'-4,4'-2,2-diphenylpropane-bis-maleimide, N,N'-alpha,alpha'-1,3-dipropylene-5,5-dimethyl-hydantoin-bis-maleimide, N,N'-4,4'-diphenylmethane-bis-itaconimide, N,N'-p-phenylene-bis-itaconimide, N,N'-4,4'-diphenylmethane-bis-dimethylmaleimide, N,N'-4,4'-2,2'-diphenylpropane-bis-dimethylmaleimide, N,N'-hexamethylene-bis-dimethylmaleimide, N,N'-4,4'-(diphenyl ether)-bis-dimethylmaleimide and N,N'-4,4'-diphenylsulphone-bis-dimethylmaleimide.

According to the invention, allylphenols and methallylphenols, or the ethers thereof, are preferably employed as the alkenylphenols or alkenylphenol ethers. Both mononuclear and polynuclear, preferably binuclear, alkenylphenols and alkenylphenol ethers can be employed.

Preferably, at least one nucleus contains both an alkenyl group and a phenolic, optionally etherified OH group.

As is known, alkenylphenols are manufactured by rearrangement of the alkenyl ethers of phenols (for example of the allyl ether of phenol) by the action of heat (Claisen rearrangement). These alkenyl ethers are also obtained according to known processes by reacting phenols and, for example, allyl chloride in the presence of an alkali metal hydroxide and solvents. As is known, a condensation reaction takes place (elimination of an alkali metal chloride).

Preferred examples are compounds of formula I, II or III 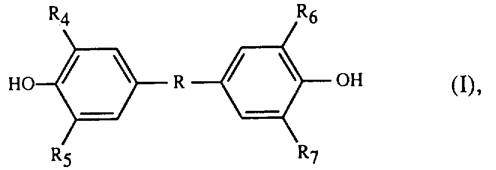 wherein R is a direct bond, methylene, isopropylidene, -O-, -S-, -SO- or -SO₂ and R₄, R₅, R₆ and R₇ are independently hydrogen or C₂-C₁₀alkenyl, preferably allyl or propenyl, with the proviso that at least one of R₄-R₇ is an alkenyl group; 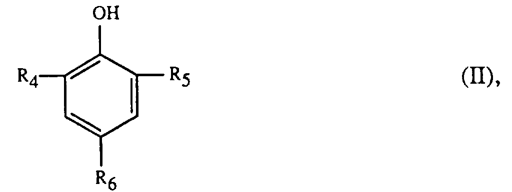 wherein R₄, R₅ and R₆ are each independently a hydrogen atom or C₂-C₁₀alkenyl, preferably, an allyl or propenyl group, with the proviso that at least one of R₄ to R₆ is alkenyl; and 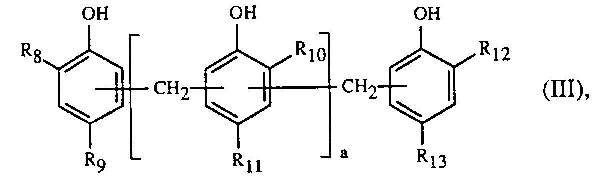 wherein R₈, R₉, R₁₀, R₁₁, R₁₂ and R₁₃ are each independently a hydrogen atom, C₁-C₄-alkyl, C₂-C₁₀alkenyl, preferably allyl or propenyl, with the proviso that at least one of R₈ to R₁₃ is alkenyl, and a is a value from 0 to 10;
or the ethers thereof containing at least one -OR₁₄ radical wherein R₁₄ is C₁-C₁₀alkyl, C₆-C₁₀aryl or C₂-C₁₀alkenyl.

Compounds of formula I are preferred in which each of R₄ and R₆ is a propenyl group and each of R₅ and R₇ is a hydrogen atom and R is methylene, isopropylidene or -O-.

Such alkenyl-substituted phenols and polyols are disclosed e.g. in U.S. patent specification 4,100,140 and 4,371,719.

Typical materials include o,o'-diallyl-bisphenol A, 4,4'-dihydroxy-3,3'diallylbiphenyl, bis(4-hydroxy-3-allylphenyl)methane, 2,2-bis-(4-hydroxy-3,5-diallylphenyl)propane, eugenol (4-allyl-2-methoxyphenol), o,o'-dimethallyl-bisphenol A, 4,4'-dihydroxy-3,3'-dimethallylbiphenyl, bis-(4-hydroxy-3-methallylphenyl)methane, 2,2-bis-(4-hydroxy-3,5-dimethallylphenyl)propane, 4-methallyl-2-methoxyphenol, 2,2-bis-(4-methoxy-3-allylphenyl)propane, 2,2-bis(4-methoxy-3-methallylphenyl)propane, 4,4'-dimethoxy-3,3'-diallylbiphenyl, 4,4'-dimethoxy-3,3'-dimethallylbiphenyl, bis(4-methoxy-3-allylphenyl)-methane, bis(4-methoxy-3-methallylphenyl)methane, 2,2-bis(4-methoxy-3,5-diallylphenyl)propane, 2,2-bis-(4-methoxy-3,5-dimethallylphenyl)propane, 4-allylveratrole (4-allyl-1,2-dimethoxybenzene) and 4-methallyl-veratrole (4-methallyl-1,2-dimethoxybenzene). o,o'-Diallyl-bisphenol A is preferred.

It is also possible to use mixtures of isomers of propenyl- and allyl-substituted mono- or polyhydric phenols. Among the mixtures of isomers it is preferred to use mixtures of propenyl- and allyl-substituted phenols of formula I, preferably those which are obtained by partial isomerization of allvl-substituted Dhenols of formula Ia 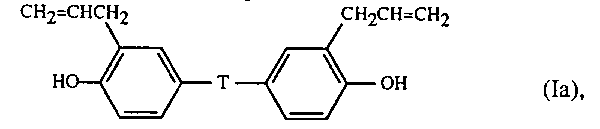 wherein T is methylene, isopropylidene or -O-.

According to the invention, the use of mixtures of polynuclear alkenylphenols and/or alkenylphenol ethers with mononuclear alkenylphenols and/or alkenylphenol ethers also gives good results.

A further embodiment of the invention is the use of mixtures of those substances which contain only one OH group and only one alkenyl group on the aromatic nucleus with substances which contain several OH groups and/or several alkenyl groups on the aromatic nucleus, or of mixtures of the corresponding phenol ethers of these substances. The corresponding methallyl compounds can also be used.

In terms of relative concentration, the alkenyl phenol component or a mixture thereof is employed in a range of 0.05 to 2.0 moles per mole of maleimide, and preferably in a range of 0.1 to 1.0, and most preferably in a 1:1 molar ratio.

Applicable catalysts are basic in nature and are tertiary, secondary and primary amines or amines which contain several amino groups of different types (for example mixed tertiary/secondary amines) and quaternary ammonium compounds. These amine catalysts can be either monoamines or polyamines. Tertiary aliphatic amines are preferred. The substances which follow are to be listed as examples of such amine catalysts: diethylamine, tributylamine, triethylamine, tripropylamine, triamylamine, benzylamine, tetramethyldiaminodiphenylmethane, N,N-di-isobutylaminoacetonitrile, N,N-dibutylaminoacetonitrile, heterocyclic bases, such as quinoline, N-methylpyrrolidine, imidazole, benzimidazole and their homologues, and also mercaptobenzothiazole. Examples of suitable quaternary ammonium compounds which may be mentioned are benzyltrimethylammonium hydroxide and benzyltrimethylammonium methoxide. Tributylamine and tripropylamine are preferred.

The method of preparation of the reaction products of this invention is established in order to obtain prepolymers of predetermined advancement. A key element is the amount of catalyst utilized in the advancement reaction. Thus, applicable concentrations of amine range from 0.01-0.11 moles of amine per mole of bismaleimide and preferably 0.025-0.075 moles per mole of bismaleimide (i.e. concentration stated on basis of two maleimide moieties). In selecting the reaction conditions, a practitioner must strike a balance between catalyst concentration and the other process variables inasmuch as higher catalyst concentrations will tend to maximize the increase in solution stability while lower amounts within the range will improve other characteristics in preference to solution stability. This balancing of variables will also permit the use of catalyst concentrations somewhat beyond the lower and upper limits. However, catalyst concentrations falling significantly below the minimum concentration do not yield resins with improved solution or storage stability, while catalyst concentrations substantially exceeding the prescribed maximum will tend to gel the resin solution during preparation or to produce resins with high resin solution viscosities and with inferior mechanical and thermal properties.

Correspondingly, the degree of resin advancement is a function of reaction time and temperature after catalyst addition. This advancement parameter is to be monitored by the measurement of resin melt viscosity. Resin melt viscosity is measured with an ICI Cone & Plate Viscometer using a 0-100 poise scale at 125°C and will range from 21 to 75 -85 poise, and preferably 50-70 poise, for the advanced resin systems. Gel time may be used as an additional parameter and reflects the time to total gel formation as determined at a temperature of 170°C and will generally range from 80 to 550 seconds for the advanced resin systems of this invention.

The advancement procedure thus involves blending the maleimide and alkenyl phenol and heating the blend at a temperature of from 25 to 125°C until a clear melt is obtained. Thereafter, the catalyst is added and the reaction continued for the appropriate amount of time at temperatures ranging from 110 to 130°C, whereupon substantially all of the catalyst is removed under vacuum. The resulting prepolymer resins may then be cast in the melt or formed as desired and cured at temperatures of between 100-250°C for the appropriate periods of time.

However, it is preferred for purposes of this invention to form a resin solution by adding the desired non-aqueous solvent medium to the resin at the conclusion of the reaction. High solids (up to about 75 %, by weight), generally low viscosity solutions are thus prepared which are stable for months at room temperature without precipitation and which are directly available for impregnating glass or other fabrics or fibers for laminate preparation. A wide variety of low boiling solvents (boiling points up to of 160°C and preferably up to 100°C) may be used including ketones such as acetone, methyl ethyl ketone and methyl isobutyl ketone; glycol ethers and glycol ether acetates such as propylene glycol methyl ether, propylene glycol methyl ether acetate, ethylene glycol methyl ether, ethylene glycol ethyl ether and glycol ethyl ether acetate; hydrocarbons such as toluene and anisole; dimethylformamide; and mixtures thereof; with the ketones and ketone/ether blends (preferably 1:1) being of particular interest. Blends of ketones with certain higher boiling solvents, particularly ketone/glycol ether blends, are also applicable.

Prepolymers such as those described above have application in a broad range of end uses such as in printed circuit boards, castings, composites, molding compounds, adhesives and coatings. Thus, the modified resin solutions or melts are utilized to impregnate various fibers or fabrics for eventual use in printed circuit boards or various laminating applications. Techniques for preparing laminates are well known. Such laminates may be prepared by compression or autoclave molding and may comprise a broad range of thicknesses. Techniques for preparing prepregs are well known to those skilled in the art. In terms of preparing honeycomb skins and structural parts, graphite, glass and Kevlar reinforced skins and parts as well as others can be readily prepared from the instant systems.

The prepolymers prepared according to the invention can furthermore be mixed, at any stage before cure, with usual modifiers such as extenders, fillers and reinforcing agents, pigments, dyestuffs, organic solvents, plasticizers, tackifiers, rubbers, accelerators, diluents, and the like. As extenders, reinforcing agents, fillers and pigments which can be employed in the curable mixtures according to the invention there may be mentioned, for example: coal tar, bitumen, glass fibers, boron fibers, carbon fibers, cellulose, polyethylene powder, polypropylene powder, mica, asbestos, quartz powder, gypsum, antimony trioxide, bentones, silica aerogel ("aerosil"), lithopone, barite, titanium dioxide, carbon black, graphite, iron oxide, or metal powders such as aluminium powder or iron powder. It is also possible to add other usual additives, for example, flameproofing agents, agents for conferring thixotropy, flow control agents such as silicones, cellulose acetate butyrate, polyvinyl butyrate, waxes, stearates and the like (which are in part also used as mold release agents) to the curable mixtures.

As previously noted, the prepolymers so prepared are distinguished by increased neat resin stability; solubility at high solids content in a broad range of solvents, particularly low boiling solvents; solution and storage stability at a broad range of temperatures; and good thermal, mechanical and chemical properties.

Subject of the invention are also products obtained by curing the heat curable compositions according to the invention.

Another subject of the invention is the product obtained by removing the solvent of the composition, which is prepared by adding a non-aqueous solvent medium to the resin at the conclusion of the advancement reaction, and curing the resulting substantially solvent-free reaction product.

Another subject of the invention is a laminate or prepreg structure comprising the cured product of a woven fabric or wound yarn impregnated with heat curable composition of the invention.

Yet another subject of the invention is a process for preparing a storage stable product containing imide groups comprising (1) reacting at temperatures ranging from 110 to 150 °C (a) a polyimide containing at least two radicals of the formula 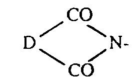 wherein D is a divalent radical containing a C=C bond, and (b) from 0.05 to 2.0 moles per mole of component (a) of an alkenyl phenol, an alkenyl phenol ether or mixtures thereof, in the presence of from 0.01-0.11 moles per one mole for each two imide moieties in component (a) of a pirmary, secondary or tertiary amine, mixed secondary/tertiary amine, heterocyclic base or quaternary ammonium compound as a basic catalyst for the reaction, for a period of time sufficient to provide said reaction product with a resin melt viscosity of from 20 to 75 poise as measured on an ICI Cone & Plate Viscometer at 125°C, (2) substantially removing the catalyst, and (3) recovering the storage stable product.

The following examples illustrate the preferred embodiments of this invention. In these examples, all parts given are by weight unless otherwise noted.

### Example 1:

This example illustrates the preparation of typical advanced resin systems of this invention.

A flask equipped with thermometer, mechanical stirrer and condenser is charged with 154 grams (0.5 mole) 4,4'-bismaleimidodiphenylmethane and 179 grams (0.5 mole) o,o'-diallyl bisphenol A and heated to 120-125°C until a clear melt is obtained. A vacuum of 2670 - 4000 Pa (20-30 mmHg) is applied for 10 minutes and the mixture is allowed to cool to 110°C. The tributylamine (TBA) catalyst is added to the mixture in the indicated amounts after releasing the vacuum, and the mixture is further reacted for the indicated time period at 110°C, i.e. until the desired melt viscosity is obtained. A vacuum of 2670 - 4000 Pa (20-30 mmHg) is applied to the system for another 10 minutes at 110°C. The temperature of the thermal controller is then reset to 75°C and 222 grams of methyl ethyl ketone (MEK) is added to the hot resin. The resin solution is stirred at 75°C for one hour and then cooled to room temperature.

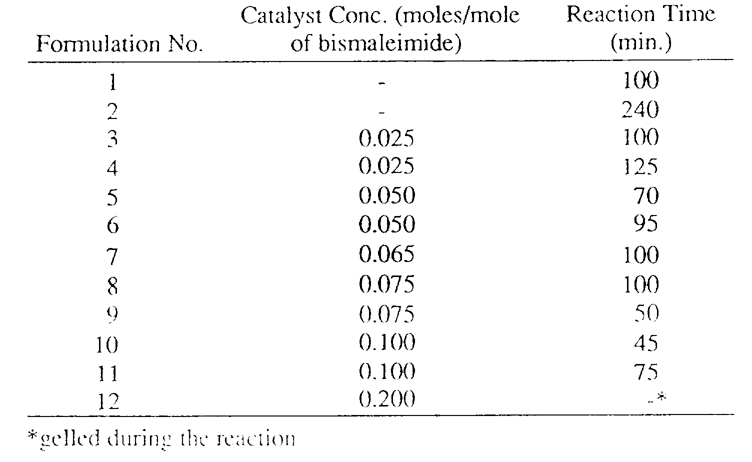

### Example 2:

The melt viscosity (MV) of each solid resin melt of Example 1 before adding solvent is determined on ICI Viscometer at 125°C. The characteristics of the resin solutions (adjusted to 60 % solids) of Example 1 are also determined as follows:

Storage Stability (SS) - The time to formation of a layer of precipitate at the bottom of the storage container maintained at room temperature.
Gel Time (GT) - The observed time to total gel formation when two grams of solution are placed in an open container on a hot plate maintained at 170°C.
Viscosity (Visc.) - Determined on Brookfiled Viscometer at 12 rpm with a No. 1 spindle at 25°C on original sample and on sample after storage for six months at room temperature (final).

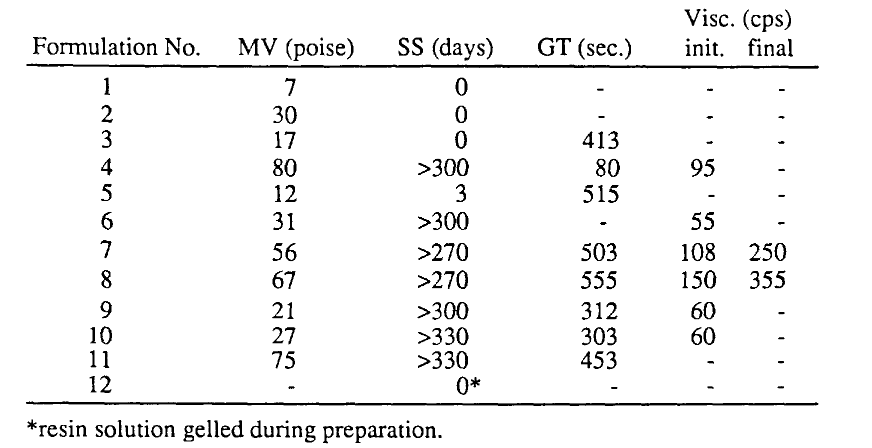

Formulations 1-5 and 12 are comparative formulations.

These data thus clearly indicate the correlation of process variables required in order to obtain the improved systems of this invention. Thus, the absence of catalyst (1,2) or the presence of excess catalyst (12) results in poor resin solution stability. The presence of adequate catalyst but inadequate reaction conditions relative thereto (3,5) again results in low melt viscosity and inadequate solution stability. Sufficient melt viscosity but no catalyst (2) also results in poor solution stability. It is balancing of the variables as noted in the other formulations that provides the increased resin solution stability of the systems of this invention as particularly evidenced by the absence of precipitation.

### Example 3:

Additional formulations are prepared according to the procedure of Example 1 and tested according to the procedures of Example 2. In these instances, the reaction times after catalyst addition at 110°-120°C are again varied, the solvent is methyl ethyl ketone and tripropylamine (TPA) and TBA are utilized as catalysts.

| Formulation No. | Catalyst | Catalyst Conc. (moles/mole of bismaleimide) | Reaction Time (min.) |
|---|---|---|---|
| 13 | TBA | 0.075 | 25 |
| 14 | TPA | 0.030 | 150 |

| Formulation No. | MV (poise) | SS (days) | GT (sec.) | Visc. (cps) | |
|---|---|---|---|---|---|
| | | | | init. | final |
| 13 | 12 | 30 | >600 | - | - |
| 14 | 85 | >240 | 205 | 98 | - |

These data thus further illustrate the impact of the correlation of variables to achieve the prescribed resin advancement on physical properties and performance.

### Example 4:

The resin systems are prepared as in Example 1. Rather than preparing solutions thereof, cured resin plaques are prepared by casting the degassed molten solution into 0.3 cm thick sheet molds and curing using the following cure cycle

| | | |
|---|---|---|
| 1 hr. | at | 180°C |
| 2 hrs. | at | 200°C |
| 6 hrs. | at | 250°C. |

Fully cured panels are obtained.

The panels are tested at room temperature for tensile properties using ASTM D-638 and for glass transition temperature (Tg) using a Perkin-Elmer DMA run at 20°C/min.

| Formulation No. | Catalyst | Catalyst Conc. (moles/mole of bismaleimide) |
|---|---|---|
| 15 | - | - |
| 16 | TBA | 0.030 |
| 17 | TBA | 0.050 |
| 18 | TBA | 0.065 |
| 19 | TBA | 0.075 |
| 20 | TPA | 0.01 |
| 21 | TPA | 0.02 |
| 22 | TPA | 0.03 |
| 23 | TPA | 0.05 |

| | 15 | 16 | 17 | 18 | 19 | 20 | 21 | 22 | 23 |
|---|---|---|---|---|---|---|---|---|---|
| Tensile Modulus (N/mm) | 3782 | - | - | 4754 | 4596 | 5106 | 3776 | 4086 | - |
| Tensile Strength (N/mm) | 56.5 | - | - | 46.2 | 37.2 | 68.9 | 50.3 | 65.5 | - |
| Tensile Elongation (%) | 1.6 | - | - | 1.1 | 0.8 | 2.1 | 1.5 | 1.9 | - |
| Tg (°C) | 328 | 310 | 250 | 257 | 210 | 340 | 340 | 330 | 270 |

The above results indicate the relatively limited adverse impact on thermal and mechanical properties of the cured resins of the instant invention as a result of the advancement process of this invention relative, for example, to control 15.

### Example 5:

A flask equipped with thermometer, mechanical stirrer and condenser is charged with one mole 4,4'-bismaleimidodiphenylmethane and one mole o,o'-diallyl bisphenol A and heated to 120-125°C until a clear melt is obtained. A vacuum of 2670 - 4000 Pa (20-30 mmHg) is applied for 10-15 minutes and the mixture is allowed to cool to 110°C. TPA catalyst (0.03 mole) is added after releasing the vacuum and the reaction continues for an additional 30 minutes at 110°C. A vacuum of 2670 - 4000 Pa (20 mmHg) is applied at 110°C for 60 minutes and then at 120°C for 30 minutes whereupon the vacuum is released.

Thereafter, 60 parts of the resin are blended with 20 parts methyl ethyl ketone at 80°C and the resin is cooled to room temperature over the period of an hour. The solution is then mixed with 20 parts propylene glycol methylether to produce the final resin solution.

The resin system exhibits the following excellent characteristics:

| | |
|---|---|
| solid resin melt viscosity (125°C) | - 63 poise |
| solid resin gel time (170°C) | - 218 seconds |
| resin solution viscosity (25°C) | - 200 cps |
| resin solution stability | - no precipitation after 6 months |

Summarizing, it is seen that this invention provides improved maleimide systems, said improvements stemming from the introduction of the desired degree of resin advancement. Variations may be made in procedures, proportions and materials without departing from the scope of the invention as defined by the following claims.

## Claims

1. A heat curable composition comprising the product resulting from the reaction of (a) a polyimide containing at least two radicals of the formula 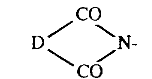 wherein D is a divalent radical containing a C=C bond, and (b) from 0.05 to 2.0 moles per mole of component (a) of an alkenyl phenol, an alkenyl phenol ether or mixtures thereof, in the presence of from 0.01 to 0.11 moles per one mole for each two imide moieties in component (a) of a primary, secondary or tertiary amine, mixed secondary/tertiary amine, heterocyclic base or quaternary ammonium compound as a basic catalyst, characterized in that said reaction product has a resin melt viscosity of from 21 to 75 poise as measured on an ICI Cone & Plate Viscometer at 125°C.

2. The composition of claim 1, wherein component (a) corresponds to the formula 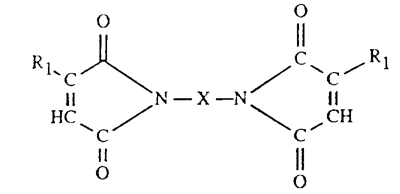 wherein R₁ is hydrogen or methyl and X is a divalent organic radical with 2-30 carbon atoms.

3. The composition of claim 2, wherein X is -CₓH₂ₓ- with x = 2-20, -CH₂CH₂SCH₂CH₂-, phenylene, naphthylene, xylylene, cyclopentylene, 1,5,5-trimethyl-1,3-cyclohexylene, 1,4-cyclohexylene, 1,4-bis(methylene)-cyclohexylene, and groups of the formula 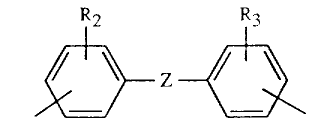 wherein R₂ and R₃ independently are chlorine, bromine, methyl, ethyl, or hydrogen, and Z is a direct bond or methylene, 2,2-propylidene, -CO-, -O-, -S-, -SO-, or -SO₂-.

4. The composition of claim 3, wherein R₁ is hydrogen, X is hexamethylene, trimethylhexamethylene, 1,5,5-trimethyl-1,3-cyclohexylene, or a group of the indicated formula in which Z is 2,2-propylidene, -O- or preferably methylene.

5. The composition of claim 1, wherein component (b) is an alkenyl phenol corresponding to the formulae I, II or III 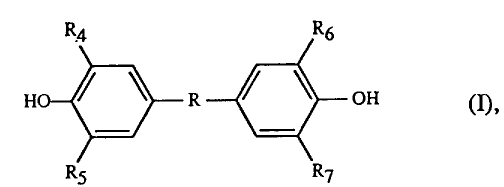 wherein R is a direct bond, methylene, isopropylidene, -O-, -S-, -SO- or -SO₂ and R₄, R₅, R₆ and R₇ are independently hydrogen or C₂-C₁₀alkenyl, with the proviso that at least one of R₄-R₇ is an alkenyl group; 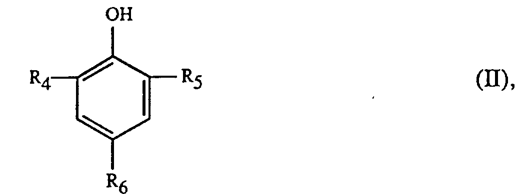 wherein R₄, R₅ and R₆ are each independently a hydrogen atom or C₂-C₁₀alkenyl, with the proviso that at least one of R₄ to R₆ is alkenyl, and 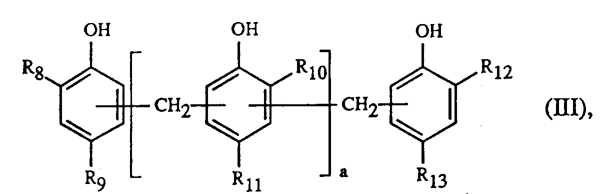 wherein R₈, R₉, R₁₀, R₁₁, R₁₂ and R₁₃ are each independently a hydrogen atom, C₁-C₄alkyl, C₂-C₁₀alkenyl, with the proviso that at least one of R₈ to R₁₃ is alkenyl, and a is a value from 0 to 10;
or the ethers thereof containing at least one -OR₁₄ radical wherein R₁₄ is C₁-C₁₀alkyl, C₆-C₁₀aryl or C₂-C₁₀alkenyl.

6. The composition of claim 1, wherein said tertiary amine is a tertiary aliphatic amine.

7. The composition of claim 1, which is dissolved in a non-aqueous solvent medium.

8. A process for preparing a storage stable product containing imide groups comprising (1) reacting at temperatures ranging from 110 to 130 °C (a) a polyimide containing at least two radicals of the formula 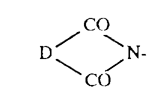 wherein D is a divalent radical containing a C=C bond, and (b) from 0.05 to 2.0 moles per mole of component (a) of an alkenyl phenol, an alkenyl phenol ether or mixtures thereof, in the presence of from 0.01-0.11 moles per one mole for each two imide moieties in component (a) of a primary secondary or tertiary amine, mixed secondary/tertiary amine, heterocyclic base or quaternary ammonium compound as a basic catalyst for the reaction (2) substantially removing the catalyst, and (3) recovering the storage stable product, characterized in that step (1) is carried out for a period of time sufficient to provide said reaction product with a resin melt viscosity of from 21 to 75 poise as measured on an ICI Cone & Plate viscosimeter at 125 °C.

9. The process of claim 8, wherein subsequent to step (2) the reaction product is dissolved in a non-aqueous solvent medium and said solution is recovered.

10. The composition of claim 5, wherein component (b) is an alkenyl phenol corresponding to formula (I), (II) or (III) wherein said alkenyl group is an allyl or propenyl group.

11. The composition of claim 7, wherein the solvent medium has a maximum boiling point of 160 °C.

## Patentansprüche

1. Eine wärmehärtbare Zusammensetzung, umfassend das Produkt von der Reaktion von (a) einem Polyimid enthaltend wenigstens zwei Reste der Formel 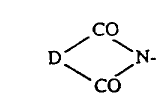 worin D ein zweiwertiger Rest enthaltend eine C=C-Bindung ist und (b) von 0,05 bis 2,0 Mole pro Mol der Komponente (a) eines Alkenylphenols, eines Alkenylphenolethers oder Mischungen davon, in Gegenwart von 0,01 bis 0,11 Mol pro 1 Mol für jede zwei Imidhälften in Komponente (a) eines primären, sekundären oder tertiären Amins, gemischtensekundären/tertiären Amins, heterocyclischer Base oder quaternärer Ammoniumverbindung als basischen Katalysator, dadurch gekennzeichnet, daß dieses Reaktionsprodukt eine Harzschmelzviskosität von 21 bis 75 Poise, gemessen auf einem ICI Cone & Plate-Viskosimeter bei 125 °C hat.

2. Zusammensetzung gemäß Anspruch 1, worin die Komponente (a) der Formel 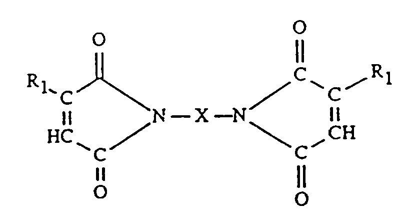 entspricht, worin R₁ Wasserstoff oder Methyl ist, und X ist ein zweiwertiger organischer Rest mit 2 bis 30 Kohlenstoffatomen.

3. Zusammensetzung gemäß Anspruch 2, worin X ist CₓH₂ₓ mit x = 2 bis 20, -CH₂CH₂SCH₂CH₂-, Phenylen, Naphthylen, Xylylen, Cyclopentylen, 1,5,5-Trimethyl-1,3-cyclohexylen, 1,4-Cyclohexylen, 1,4-Bis(methylen)-cyclohexylen und Gruppen der Formel 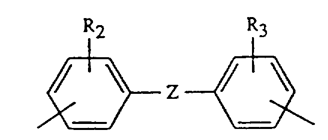 ist, worin R₂ und R₃ unabhängig Chlor, Brom, Methyl, Ethyl oder Wasserstoff sind, und Z ist eine direkte Bindung oder Methylen, 2,2-Propyliden, -CO-, -O-, -S-, -SO- oder -SO₂-.

4. Zusammensetzung gemäß Anspruch 3, worin R₁ Wasserstoff ist, X ist Hexamethylen, Trimethylhexamethylen, 1,5,5,-Trimethyl-1,3-cyclohexylen, oder eine Gruppe der angegebenen Formel, worin Z 2,2-Propyliden, -O- oder vorzugsweise Methylen ist.

5. Zusammensetzung gemäß Anspruch 1, worin die Komponente (b) ein Alkenylphenol entsprechend den Formeln I, II oder III ist, 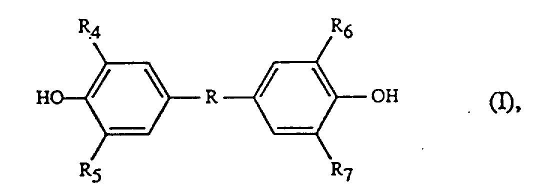 worin R eine direkte Bindung, Methylen, Isopropyliden, -O-, -S-, -SO- oder -SO₂ ist, und R₄, R₅, R₆ und R₇ sind unabhängig Wasserstoff oder C₂-C₁₀-Alkenyl, mit der Maßgabe, daß wenigstens eines von R₄ bis R₇ eine Alkenylgruppe ist; 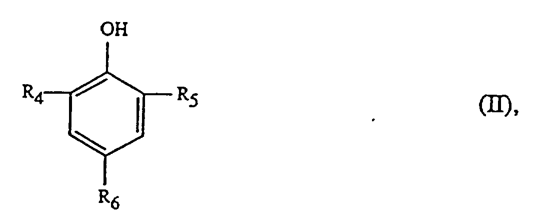 worin R₄, R₅ und R₆ jeweils unabhängig ein Wasserstoffatom oder C₂-C₁₀-Alkenyl sind, mit der Maßgabe, daß wenigstens eines von R₄ bis R₆ Alkenyl ist, und 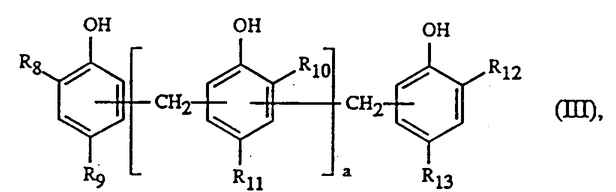 worin R₈, R₉, R₁₀, R₁₁, R₁₂ und R₁₃ jeweils unabhängig Wasserstoff, C₁-C₄-Alkyl, C₂-C₁₀-Alkenyl sind, mit der Maßgabe, daß wenigstens eines von R₈ bis R₁₃ Alkenyl ist, und a ist ein Wert von 0 bis 10;
oder die Ether davon, enthaltend wenigstens einen Rest -OR₁₄, worin R₁₄ C₁-C₁₀-Alkyl, C₆-C₁₀-Aryl oder C₂-C₁₀-Alkenyl ist.

6. Zusammensetzung gemäß Anspruch 1, worin dieses tertiäre Amin eines tertiäres aliphatisches Amin ist.

7. Zusammensetzung gemäß Anspruch 1, die in einem nichtwäßrigen Lösungsmittelmedium gelöst ist.

8. Verfahren zur Herstellung eines lagerbeständigen Produkts, enthaltend Imidgruppen, umfassend (1) die Reaktion bei Temperaturen im Bereich von 110 bis 130 °C von (a) einem Polyimid, enthaltend wenigstens zwei Reste der Formel 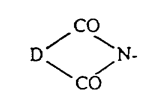 worin D ein zweiwertiger Rest, enthaltend eine C=C-Bindung, ist, und (b) von 0,05 bis 2,0 Mole pro Mol der Komponente (a) eines Alkenylphenols, eines Alkenylphenolethers oder Mischungen davon, in Gegenwart von 0,01 bis 0,11 Mol pro 1 Mol für jede zwei Imidhälften in Komponente (a) eines primären, sekundären oder tertiären Amins, gemischten sekundären/tertiären Amins, heterocyclischer Base oder quaternärer Ammoniumverbindung als basischen Katalysator für die Reaktion, (2) im wesentlichen Entfernen des Katalysators und (3) Gewinnen des lagerbeständigen Produkts, dadurch gekennzeichnet, daß Stufe (1) während einer Zeitdauer durchgeführt wird, die ausreichend ist, um dieses Reaktionsprodukt mit einer Harzschmelzviskosität von 21 bis 75 Poise, gemessen auf einem ICI Cone & Plate-Viskosimeter bei 125 °C, zu liefern.

9. Verfahren gemäß Anspruch 8, worin anschließend an Stufe (2) das Reaktionsprodukt in einem nichtwäßrigen Lösungsmittelmedium gelöst und diese Lösung gewonnen wird.

10. Zusammensetzung gemäß Anspruch 5, worin die Komponente (b) ein Alkenylphenol entsprechend der Formel I, II oder III ist, worin die genannte Alkenylgruppe eine Allyl- oder Propenylpruppe ist.

11. Zusammensetzung gemäß Anspruch 7, worin das Lösungsmittelmedium einen maximalen Siedepunkt von 160 °C hat.

## Revendications

1. Composition durcissable à chaud comprenant le produit résultant de la réaction de (a) un polyimide contenant au moins deux radicaux de formule 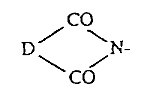 dans laquelle D est un radical divalent contenant une liaison C=C, et (b) de 0,05 à 2,0 moles par mole de composant (a) d'un alcényl-phénol, d'un éther d'alcényl-phénol ou d'un de leurs mélanges, en présence de 0,01 à 0,11 mole pour une mole de chacune des deux parties imide du composant (a) d'une amine primaire, secondaire ou tertiaire, d'une amine mixte secondaire/tertiaire, d'une base hétérocyclique ou d'un composé de type ammonium quaternaire en tant que catalyseur basique, caractérisée en ce que ledit produit de réaction a une viscosité à l'état fondu de la résine allant de 21 à 75 poises telle que mesurée sur un viscosimètre ICI Cone & Plate à 125°C.

2. Composition selon la revendication 1, dans laquelle le composant (a) correspond à la formule 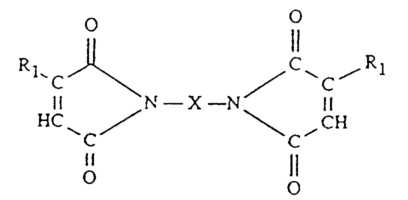 dans laquelle R₁ est un hydrogène ou un méthyle et X est un radical organique divalent ayant de 2 à 30 atomes de carbone.

3. Composition selon la revendication 2, dans laquelle X est -CₓH₂ₓ- avec x allant de 2 à 20, -CH₂CH₂SCH₂CH₂-, phénylène, naphtylène, xylylène, cyclopentylène, 1,5,5-triméthyl-1,3-cyclohexylène, 1,4-cyclohexylène, 1,4-bis-(méthylène)cyclohexylène, et des groupes de formule 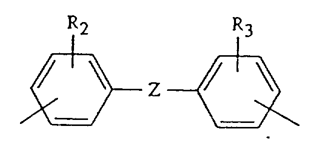 dans laquelle R₂ et R₃ sont indépendamment l'un de l'autre un chlore, un brome, un méthyle, un éthyle ou un hydrogène, et Z est une liaison directe ou un méthylène, un 2,2-propylidène, -CO-, -O-, -S-, -SO- ou -SO₂-.

4. Composition selon la revendication 3, dans laquelle R₁ est un hydrogène, X est un hexaméthylène, un triméthylhexaméthylène, un 1,5,5-triméthyl-1,3-cyclohexylène, ou un groupe de formule indiquée dans laquelle Z est un 2,2-propylidène, un -O- ou de préférence un méthylène.

5. Composition selon la revendication 1, dans laquelle le composant (b) est un alcényl-phénol correspondant aux formules I, II ou III 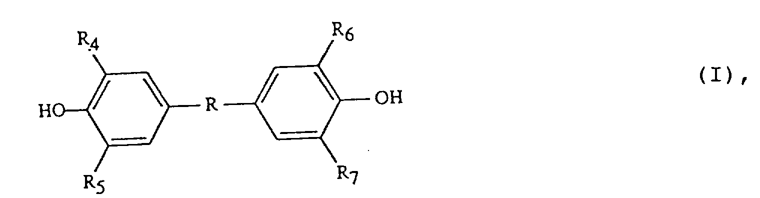 dans lesquelles R est une liaison directe, un méthylène, un isopropylidène, -O-, -S-, -SO- ou -SO₂- et R₄, R₅, R₆ et R₇ sont, indépendamment l'un de l'autre, un hydrogène ou un alcényle en C₂-C₁₀, à la condition qu'au moins un des R₄ à R₇ soit un groupe alcényle ; 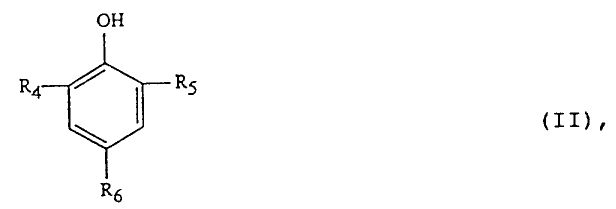 dans laquelle R₄, R₅ et R₆ sont chacun, indépendamment l'un de l'autre, un atome d'hydrogène ou un alcényle en C₂-C₁₀, à la condition qu'au moins un des R₄ à R₆ soit un alcényle ; et 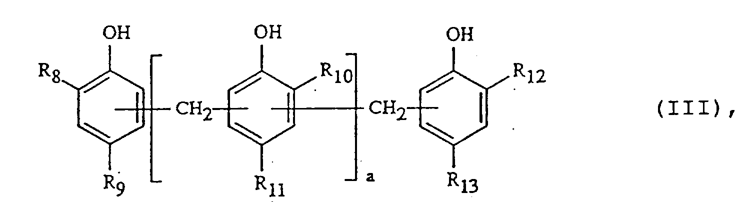 dans laquelle R₈, R₉, R₁₀, R₁₁, R₁₂ et R₁₃ sont chacun, indépendamment l'un de l'autre, un atome d'hydrogène, un alkyle en C₁-C₄, un alcényle en C₂-C₁₀, à la condition qu'au moins l'un des R₈ à R₁₃ soit un alcényle, et a va de 0 à 10 ;
ou leurs éthers contenant au moins un radical -OR₁₄ dans lequel R₁₄ est un alkyle en C₁-C₁₀, un aryle en C₆-C₁₀ ou un alcényle en C₂-C₁₀.

6. Composition selon la revendication 1, dans laquelle ladite amine tertiaire est une amine aliphatique tertiaire.

7. Composition selon la revendication 1, qui est dissoute dans un milieu de solvant non aqueux.

8. Procédé de préparation d'un produit stable au stockage contenant des groupes imide comprenant (I) la réaction à des températures allant de 110 à 130°C de (a) un polyimide contenant au moins deux radicaux de formule 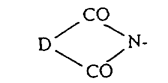 dans laquelle D est un radical divalent contenant une liaison C=C, et (b) de 0,05 à 2,0 moles par mole du composant (a) d'un alcényl-phénol, d'un éther d'alcényl-phénol ou d'un de leurs mélanges, en présence de 0,01 à 0,11 mole pour une mole de chacune des deux parties imide en le composant (a) d'une amine primaire, secondaire ou tertiaire, d'une amine mixte secondaire/tertiaire, d'une base hétérocyclique ou d'un composé de type ammonium quaternaire en tant que catalyseur basique pour la réaction, (2) l'élimination de manière substantielle du catalyseur, et (3) la récupération du produit stable au stockage, caractérisé en ce que l'étape (1) est effectuée pendant une durée suffisante pour fournir ledit produit de réaction avec une viscosité à l'état fondu de la résine allant de 21 à 75 poises telle que mesurée sur un viscosimètre ICI Cone & Plate à 125°C.

9. Procédé selon la revendication 8, dans lequel, à la suite de l'étape (2), le produit de réaction est dissous dans un milieu de solvant non aqueux et on récupère ladite solution.

10. Composition selon la revendication 5, dans laquelle le composant (b) est un alcényl-phénol correspondant à la formule (I), (II) ou (III) dans lesquelles ledit groupe alcényle est un groupe allyle ou propènyle.

11. Composition selon la revendication 7, dans laquelle le milieu de solvant a un point d'ébullition maximum de 160°C.
